# EUROPÄISCHE PATENTSCHRIFT

(11) **EP 1 269 450 B1**
(45) Veröffentlichungstag und Bekanntmachung des Hinweises auf die Patenterteilung: **28.01.2009**
(21) Anmeldenummer: 01916902.8
(22) Anmeldetag: 05.03.2001
(51) Int. Cl.: G09F 3/00, B41M 5/24, G09F 7/16

(54) **BAUELEMENT MIT BESCHRIFTUNG**
COMPONENT PROVIDED WITH A DESCRIPTION
COMPOSANT POURVU D'UNE INSCRIPTION

(30) Priorität: 05.04.2000 DE 10016867
(43) Veröffentlichungstag der Anmeldung: 02.01.2003
(73) Patentinhaber: EPCOS AG, 81669 München (DE)
(72) Erfinder: STELZL, Alois, 80336 München (DE); KRÜGER, Hans, 81737 München (DE); CHRISTL, Ernst, 84137 Vilsbiburg (DE)
(74) Vertreter: Epping - Hermann - Fischer
(86) Internationale Anmeldenummer: PCT/DE2001/000833
(87) Internationale Veröffentlichungsnummer: WO 2001/078041

(56) Entgegenhaltungen:
- DE-A- 3 939 575
- PATENT ABSTRACTS OF JAPAN vol. 1999, no. 11, 30. September 1999 (1999-09-30) & JP 11 156565 A (TOSHIBA CORP), 15. Juni 1999 (1999-06-15) & US 6 143 587 A (OMIZO) 7. November 2000 (2000-11-07)
- PATENT ABSTRACTS OF JAPAN vol. 018, no. 449 (M-1660), 22. August 1994 (1994-08-22) & JP 06 142952 A (TOSHIBA CORP), 24. Mai 1994 (1994-05-24)

## Beschreibung

Die Erfindung betrifft ein Bauelement, insbesondere ein miniaturisiertes passives Bauelement.

Zur Kennzeichnung von elektrischen, elektronischen und insbesondere passiven Bauelementen werden diese üblicherweise mit einer Beschriftung versehen. Diese kann Auskunft geben über den Hersteller, den Typ oder die Spezifikationen des Bauelements und ggf. die Seriennummer oder Artikelbezeichnung. Größere Bauelemente, die ausreichend große Flächen zur Aufnahme einer Beschriftung aufweisen, können dazu in einfacher Weise beispielsweise mittels Siebdruck bedruckt werden. Bei kleineren Bauelementen mit Dimensionen von z.B. unterhalb 1mm steht nicht genügend bedruckbare Fläche zur Herstellung einer Beschriftung zur Verfügung. Alternativ können diese Bauelemente mittels eines Lasers beschriftet werden, der das Erzeugen auch kleinster Schriftgrößen noch ermöglicht (siehe dazu JP-A-11156565.)

Auf miniaturisierten Bauelemente, die auf den für eine Beschriftung zur Verfügung stehenden Flächen eine metallische Schicht aufweisen, lassen sich mittels Laserbeschriftung nur schwierig lesbare oder gar keine Beschriftungen erzeugen, da dort durch Materialabtrag kein ausreichende Kontrast geschaffen werden kann.

Aufgabe der vorliegenden Erfindung ist es daher, ein Bauelement mit insbesondere metallischer Abdeckschicht anzugeben, auf dem eine kontrastreiche Beschriftung möglich ist.

Diese Aufgabe wird erfindungsgemäß durch ein Bauelement nach Anspruch 1 gelöst. Vorteilhafte Ausgestaltungen der Erfindung gehen aus den Unteransprüchen hervor.

Bei einem Bauelement, das auf einer zur Beschriftung zur Verfügung stehenden Oberfläche eine metallische Schicht, insbesondere eine Abdeckschicht aufweist, wird vorgeschlagen, über der metallischen Schicht eine Kontrastschicht anzuordnen, die mit einem Laser abtragbar ist. Auf diese Weise gelingt es, in der Kontrastschicht mittels Laserbeschriftung, also durch partiellen Schichtabtrag eine gut lesbare Beschriftung mit hohem optischen Kontrast in einfacher Weise auszubilden.

Für die Kontrastschicht kommen prinzipiell alle Schichten in Frage, die einfach aufzubringen sind und die einen guten optischen Kontrast zur metallischen Abdeckschicht aufweisen. Einfach aufzubringen sind insbesondere solche Kontrastschichten, die mit den Herstellschritten des Bauelements kompatibel sind. Besonders bevorzugt sind solche Abdeckschichten, deren Aufbringung nahtlos in den Herstellungsprozeß des Bauelements eingebracht werden kann und welche insbesondere die gleichen Apparaturen nutzen können, die für vorhergehende Verfahrensschritte bei der Herstellung des Bauelements benötigt werden.

In einer vorteilhaften Ausgestaltung der Erfindung wird die Kontrastschicht unmittelbar nach der Herstellung der metallischen Abdeckschicht erzeugt, wobei vorzugsweise die Kontrastschicht ebenfalls eine metallische Schicht ist, die sich bezüglich ihrer optischen Eigenschaften von der metallischen Abdeckschicht unterscheidet. Eine Unterscheidung zweier metallischer Schichten kann beispielsweise über das Reflexionsverhalten der metallischen Schichten erreicht werden, welches insbesondere von der Modifikation bzw. Feinstruktur der Schicht abhängig ist. Alternativ oder zusätzlich kann sich die Kontrastschicht von der metallischen Abdeckschicht in der Farbe unterscheiden bzw. können für die Schichten unterschiedlich farbige Metalle verwendet werden.

Für die Kontrastschicht können jedoch andere Materialien gewählt werden, beispielsweise Lackschichten und insbesondere gefärbte, vor allem schwarz gefärbte Lackschichten. Allgemein ist es von Vorteil, wenn die Kontrastschicht gegenüber der Metallschicht eine andere Farbe aufweist oder insbesondere eine schwarze Schicht ist.

Rein metallische übereinander erzeugte Schichtkombinationen, in denen sich durch Laserbeschriftung ein guter optischer Kontrast erzeugen läßt, und die seriell und insbesondere mit der gleichen oder ähnlichen Vorrichtung aufgebracht werden können, sind beispielsweise:
a) Kupfer/Glanznickel/Schwarznickel
b) Glanzkupfer/Nickel/Schwarznickel
c) Kupfer/Nickel(Matt)/Nickel(Grau)
d) Kupfer/Aluminium/Aluminium eloxiert

Diese Schichtkombinationen können zusätzlich über der metallischen Abdeckschicht aufgebracht werden. Ein oder zwei Metallschichten der genannten Schichtfolgen können jedoch auch die Abdeckschicht bilden oder funktionelle Aufgaben der Abdeckschicht mit übernehmen.

Bevorzugte Schichtkombinationen sind solche, die zwei unterschiedliche Modifikationen ein und desselben Metalls umfassen. Diese werden insbesondere durch unterschiedliche Herstellbedingungen erzeugt. Beim Aufbringen der metallischen Schichten durch Aufsputtern, stromloses Abscheiden oder galvanisches Abscheiden können durch Variation der Verfahrensparameter oder Abscheidebedingungen beispielsweise die Zusammensetzung oder die entsprechenden optischen Schichteigenschaften eingestellt werden.

Seriell aufbringbare und eine Metallschicht (auch Abdeckschicht) umfassende Schichtfolgen, die gegeneinander einen optischen Kontrast ausbilden, und die mit einem Laser beschriftbar bzw. abtragbar sind, sind auch die folgenden Metall/Metallkombinationen, die sich durch unterschiedliche Metallfärbung auszeichnen:
e) Nickel/Gold
f) Kupfer/Nickel
g) Kupfer/Aluminium
h) Kupfer/Zinn
i) Kupfer/Silber

Für diese unterschiedlich gefärbten Metallschichtkombinationen, von denen zumindest die untere Schicht die metallische Abdeckschicht oder Teil der metallischen Abdeckschicht sein kann, sind gleiche Abscheidebedingungen bevorzugt. Obgleich hier der Kontrast allein durch unterschiedlich gefärbte Metallschichten, bzw. die nach der Laserbeschriftung verbleibenden Metallschichtbereiche erzeugt wird, kann zusätzlich zu dem Farbkontrast noch ein Reflexionskontrast hergestellt werden. Bevorzugt ist dabei, wenn die obere Schicht (Kontrastschicht) schlecht reflektiert, die untere, durch Laserbeschriftung freilegbare Schicht dagegen gute reflektierende Eigenschaften aufweist.

Zur Aufbringung einer aus Lack und insbesondere aus Schwarzlack bestehenden Kontrastschicht eignet sich auch ein elektrophoretisches Verfahren. Für diese sind eine Reihe unterschiedlicher Lacke geeignet, an deren Material bzw. Zusammensetzung außer dem Kontrast ansonsten keine oder wenig Anforderungen zu stellen sind. Möglich ist es jedoch auch, die einen Lack umfassende Kontrastschicht aufzudrucken, aufzutropfen oder zu vergießen.

Vorteilhafte Anwendung findet die Erfindung bei Bauelementen, die eine metallische Abdeckschicht als funktionelle Schicht aufweisen oder benötigen. Eine solche metallische Abdeckschicht kann beispielsweise eine metallische Abdeckkappe sein. Die metallische Abdeckschicht kann aber auch ein metallisches Gehäuse oder Teil eines solchen sein, in dem ein beliebiges Bauelement angeordnet ist. Metallische Abdeckschichten werden insbesondere auch als Abschirmschichten gegenüber elektromagnetischer Strahlung verwendet. Eine solche Abschirmung kann erforderlich sein, um das Abstrahlen elektromagnetischer Strahlung aus dem Bauelement selbst zu verhindern. Möglich ist jedoch ein Bauelement, das ein metallische Abdeckschicht aufweist, die zur Abschirmung von außen einwirkender elektromagnetischer Strahlung dient, insbesondere wenn das Bauelement gegen die elektromagnetische Strahlung empfindlich ist. Vorzugsweise sind die Bauelemente daher hochfrequent betriebene Bauelemente, insbesondere Oberflächenwellenbauelemente für den HF-Bereich.

Im folgenden wird die Erfindung anhand eines Ausführungsbeispiels und der dazu gehörigen zwei Figuren näher erläutert.
- Figur 1: zeigt auf einem Träger aufgebrachte Bauelemente mit einer mehrschichtigen Metallisierung im schematischen Querschnitt
- Figur 2: zeigt eine in der mehrschichtigen Metallisierung erzeugte Beschriftung im schematischen Querschnitt.

### Ausführungsbeispiel:

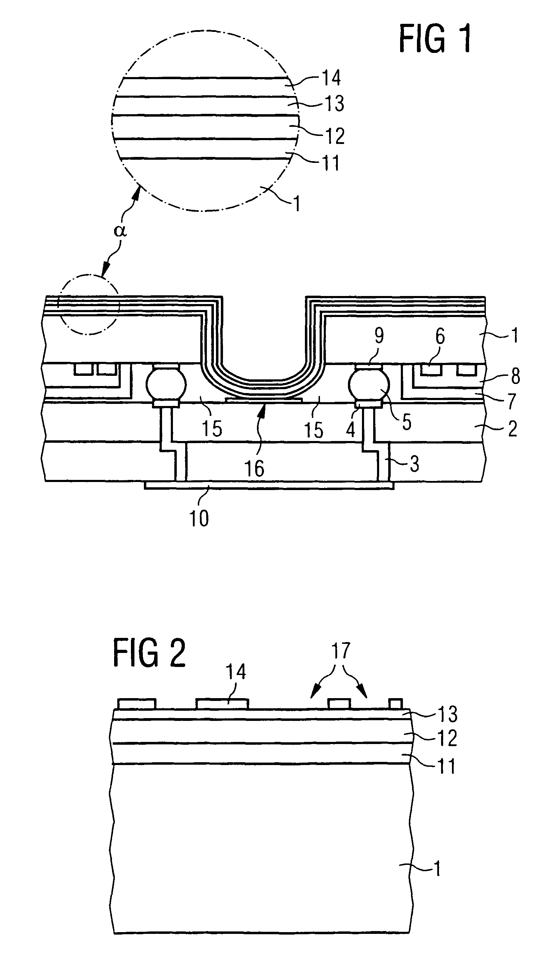

Figur 1: Bevorzugte Anwendung findet die Erfindung bei Oberflächenwellenbauelementen, insbesondere Oberflächenwellenfiltern, die in Flip-Chip-Technologie auf Basissubstraten 2 aufgebracht sind. Dabei wird das piezoelektrische Bauelementsubstrat 1, welches die aktiven Bauelementstrukturen 6 trägt, über geeignete Lotverbindungen 5, insbesondere über Bumps face-down (Kopfüber) mit dem Panel 2 verbunden, so daß die Bauelementstrukturen zwischen Bauelementsubstrat und Panel in lichtem Abstand zu letzterem geschützt angeordnet sind. Vorzugsweise werden dabei mehrere Bauelemente auf einem Panel aufgebracht und erst nach Vervollständigung aller Abdeckschichten vereinzelt. Zusätzlich können wie dargestellt die aktiven Bauelementstrukturen 6 noch mit einer Abdeckkappe 7 abgedeckt sein, die in einem von der Anmelderin als PROTEC bezeichneten integrierten Verfahren direkt auf der Oberfläche des Bauelementsubstrats 1 (Chip) erzeugt wird. Diese beläßt über den Bauelementstrukturen 6 einen lichten Hohlraum, der diese während des Verfahrens mechanisch schützt.

Die Bumps 5 verbinden die Anschlußpads 9 auf dem Chip 1 ,, die mit den aktiven Bauelementstrukturen 6 elektrisch leitend verbunden sind, mit der Underbump-Metallisierung auf dem Basis 2. Über Durchkontaktierungen 3 im Panel wird eine elektrisch leitende Verbindung zu den Anschlußmetallisierungen 10 auf der Unterseite des Panel 2 hergestellt, mit deren Hilfe das Bauelement mit einer beispielsweise auf einer Leiterplatte oder einem Modul erzeugten Schaltung in SMD Bauweise verbunden werden kann. Das Panel ist aus Kunststoff oder Keramik und vorzugsweise zweilagig ausgebildet. Dies schafft eine Metallsierungsebene zwischen den Lagen, so daß Leiterbahnen kreuzungsfrei geführt werden können. Außerdem erlaubt dies seitlich gegeneinander versetzte Durchkontaktierungen 3, die im Gegensatz zu geradlinig durch das Panel 2 führenden Durchkontaktierungen hermetisch dicht hergestellt werden können.

Zur Abschirmung gegenüber elektromagnetischer Strahlung ist auf der Rückseite des Bauelementsubstrats eine hier mehrere Schichten 11, 12, 13, 14 umfassende metallische Schicht so aufgebracht, daß sie hermetisch gegen das Panel 2 abschließt und so das gesamte Bauelement hermetisch abdichtet. Dazu kann in einem vorigen Schritt als Versiegelung ein Underfiller 15 aufgebracht werden, die das Bauelementsubstrat 1 ringförmig umgibt und zumindest im Außenbereich des Bauelementsubstrats den Freiraum zwischen Bauelementsubstrat 1 und Panel 2 verschließt (siehe Figur 1). Der Underfiller 15 kann durch Aufbringen und Aushärten einer flüssigen Abdichtmasse, insbesondere eines Lackes oder Harzes erzeugt werden. Möglich ist es jedoch auch, zur Abdichtung eine dicht an Bauelement und am Basissubstrat anliegende Kunststoff-, Metall- oder Laminatfolie aufzubringen (in der Figur nicht dargestellt).

Auf dem Bauelementsubstrat 1 oder ggf. auf der Versiegelung mittels Folie kann nun die metallische Abdeckschicht aufgebracht werden. Dies kann beispielsweise in Form einer metallischen Folie erfolgen. Die metallische Schicht kann aber auch die äußere Schicht einer mehrschichtigen Laminatfolie sein, die zur Versiegelung des Bauelements eingesetzt wird. Möglich ist es jedoch auch, die metallische Abdeckschicht durch Metallisierung und anschließende galvanische Verstärkung zu erzeugen. Dies hat den Vorteil, daß auf die gleiche Weise anschließend gleich die Kontrastschicht, vorzugsweise als weitere metallische Schicht, erzeugt werden kann.

Dazu wird zunächst die zu metallisierende Oberfläche (Rückseite des Chips 1, Oberfläche des Underfillers 15 und neben dem aufgebrachten Chip 1 freiliegende Oberfläche des Panel 2) zunächst aktiviert, beispielsweise mit PdCl₂-Lösung bei leicht erhöhter Temperatur. Auf der so aktivierten Oberfläche wird nun als erste Schicht eine chemische Metallisierung stromlos abgeschieden, beispielsweise eine ca. 2-3 µm dicke Kupferschicht 11 in einem stark alkalischen chemischen Kupferbad.

Die Kupferschicht 11 wird anschließend galvanisch verstärkt, beispielsweise mit einer weiteren Kupferschicht 12 in einem sauren Kupferbad bei Raumtemperatur. Als Passivierungsschicht wird darüber nun in einem sauren Mattnickelbad eine Nickelschicht 13 abgeschieden, die eine Teilschicht für den Kontrast der späteren Beschriftung darstellt. Als dazugehörige Kontrastschicht wird darüber nun in einem sauren Schwarznikkelbad eine ca. 0,3 µm dünne Schwarzvernickelung erzeugt.

Figur 2: Durch selektive Belichtung mit einem Laser, beispielsweise einem NdYAG Laser, wird nun ein Teil der Kontrastschicht 14 selektiv entfernt, was durch das hohe Absorptionsvermögen der dunklen Schwarznickelschicht unterstützt wird. In den so freigelegten Bereichen tritt die Oberfläche der metallisch glänzenden Nickelschicht 13 zutage und bildet mit den verbleibenden Schichtbereichen der Schwarznickelschicht 14 eine gut erkennbaren Kontrast.

Wie dargestellt wird die Erfindung vorteilhaft eingesetzt bei Bauelementen, die nach dem von der Anmelderin CSSP-Verfahren (Chip Sized SAW Package) genannten Verfahren aufgebracht und umhüllt sind. Das mittels Flip-Chip-Technologie auf einem Panel 2 aufgebrachte Bauelementsubstrat 1 weist im Unterschied zu herkömmlicher Technik im wesentlichen die gleichen Ausmasse wie das Panel 2 auf und ermöglicht daher eine weitere Miniaturisierung des Bauelements bzw. der Bauelementverpackung. Mehrere gemeinsam auf einem Panel 2 aufgebrachte und erfindungsgemäß abgedeckte Bauelemente werden anschließend vereinzelt, z.B. durch Sägen an einer Trennstelle 16 zwischen den aufgelöteten Bauelementsubstraten (siehe Figur 1).

Selbstverständlich ist die Erfindung nicht auf die Anwendung bei OFW-Bauelementen beschränkt. Vorzugsweise findet sie jedoch Verwendung für miniaturisierte Bauelemente, die eine herkömmliche Beschriftung mittels Bedrucken aufgrund der geringen zur Verfügung stehenden Oberfläche nicht ermöglichen und bei denen eine direkte Laserbeschriftung aufgrund der metallischen Abdeckschicht nicht möglich oder nur mit schlechtem Kontrast erzeugbar ist.

## Patentansprüche

1. Bauelement mit metallischer Abdeckschicht (11, 12, 13), bei dem über der metallischen Abdeckschicht zumindest eine weitere Metallschicht als Kontrastschicht (14) angeordnet ist, die mit der metallischen Abdeckschicht einen optischen Kontrast bildet und die zur Herstellung einer Beschriftung mittels Laser abtragbar ist.

2. Bauelement nach Anspruch 1,
bei dem der optische Kontrast **dadurch** erreicht ist, daß die Abdeckschicht (13) eine reflektierende und die Kontrastschicht (14) eine matte Schicht ist oder umgekehrt.

3. Bauelement nach einem der Ansprüche 1 oder 2,
bei dem der optische Kontrast **dadurch** erreicht ist, daß Abdeckschicht (13) und Kontrastschicht (14) unterschiedlich gefärbt sind.

4. Bauelement nach einem der Ansprüche 1-3,
bei dem die Kontrastschicht (14) eine schwarze Schicht und die Abdeckschicht 13) metallisch glänzend ist.

5. Bauelement nach einem der Ansprüche 1-4,
bei dem die Kontrastschicht (14) eine Schwarznickelschicht ist.

6. Bauelement nach einem der Ansprüche 1 - 5,
bei dem die Kombination aus Abdeckschicht (13) und Kontrastschicht (14) eine der folgenden Materialkombinationen umfaßt: Ni/Au; Cu/Ni; Cu/Al; Cu/Sn; Cu/Au.

7. Bauelement nach einem der Ansprüche 1 - 6,
versehen mit zumindest einer Kontrastschicht (14) über der metallischen Abdeckschicht (13), bei mit einer Laserbeschriftung Bereiche (17) der Kontrastschicht unter Freilegung der Abdeckschicht (13) abgehoben sind.

8. Bauelement nach Anspruch 7,
ausgebildet als OFW Bauelement mit einer HF abschirmenden Abdeckschicht (11,12,13).

9. Bauelement nach Anspruch 8,
das in Flip Chip Technik auf einem Panel (2) befestigt ist und bei dem die metallische Abdeckschicht (13) auf der Rückseite des Bauelements (1) aufgebracht ist und dieses hermetisch gegen das Panel (2) abschließt.

10. Verfahren zur Herstellung eines beschriftbaren
Bauelements mit den Schritten Aufbringen einer metallischen Abdeckschicht auf dem Bauelement,
Aufbringen zumindest einer metallischen Kontrastschicht auf der Abdeckschicht unmittelbar nach dem Aufbringen der Abdeckschicht,
wobei die Kontrastschicht so ausgewählt oder unter solchen Bedingungen erzeugt wird, daß sie sich bezüglich ihrer optischen Eigenschaften von der metallischen Abdeckschicht unterscheidet.

11. Verfahren nach Anspruch 10,
bei dem zum Aufbringen von Abdeckschicht und der zumindest einen Kontrastschicht die gleichen Apparaturen verwendet werden.

12. Verfahren nach Anspruch 10 oder 11,
bei dem das Aufbringen der Abdeckschicht und der Kontrastschicht durch stromloses oder galvanisches Abscheiden erfolgt.

13. Verfahren nach Anspruch 10 oder 11,
bei dem das Aufbringen der metallischen Schichten durch Aufsputtern erfolgt.

14. Verfahren nach einem der Ansprüche 12 oder 13,
bei dem die entsprechenden unterschiedlichen optischen Schichteigenschaften der Abdeckschicht und der Kontrastschicht durch Variation der Verfahrensparameter oder Abscheidebedingungen eingestellt werden.

15. Verfahren nach einem der Ansprüche 12 oder 13,
bei dem unterschiedliche Zusammensetzungen der Abdeckschicht und der Kontrastschicht durch Variation der Verfahrensparameter oder Abscheidebedingungen eingestellt werden.

16. Verfahren nach einem der Ansprüche 10 - 13,
bei dem Abdeckschicht und Kontrastschicht eine der folgenden Schichtfolgen mit unterschiedlicher Metallfärbung umfassen, und bei dem die Schichtfolge seriell aufgebracht wird:
e) Nickel/Gold
f) Kupfer/Nickel
g) Kupfer/Aluminium
h) Kupfer/Zinn
i) Kupfer/Silber

17. Verfahren nach einem der Ansprüche 10 - 16,
bei dem eine der folgenden Schichtkombinationen übereinander erzeugt werden:
a) Kupfer/Glanznickel/Schwarznickel
b) Glanzkupfer/Nickel/Schwarznickel
c) Kupfer/Nickel(Matt)/Nickel(Grau)
d) Kupfer/Aluminium/Aluminium eloxiert
wobei diese Schichtkombinationen als Kontrastschichten über der metallischen Abdeckschicht aufgebracht werden oder wobei zumindest eine der Metallschichten der genannten Schichtfolgen Teil der Abdeckschicht sind.

18. Verfahren nach einem der Ansprüche 10 - 17,
bei dem anschließend mit einem Laser Schichtbereiche der zumindest einen Kontrastschicht abgehoben werden, wobei **dadurch** eine einen optischen Kontrast bildende Beschriftung oder Kennzeichnung auf dem Bauelement erzeugt wird.

## Claims

1. Component having a metallic cover layer (11, 12, 13), wherein there is arranged over the metallic cover layer at least one further metal layer as contrast layer (14), which forms an optical contrast with the metallic cover layer and which can be eroded by means of a laser in order to produce an inscription.

2. Component according to Claim 1,
wherein the optical contrast is achieved by the cover layer (13) being a reflective layer and the contrast layer (14) being a matt layer, or vice versa.

3. Component according to either of Claims 1 and 2,
wherein the optical contrast is achieved by cover layer (13) and contrast layer (14) being differently coloured.

4. Component according to any of Claims 1-3,
wherein the contrast layer (14) is a black layer and the cover layer (13) is metallically lustrous.

5. Component according to any of Claims 1-4,
wherein the contrast layer (14) is a black nickel layer.

6. Component according to any of Claims 1-5,
wherein the combination of cover layer (13) and contrast layer (14) comprises one of the following material combinations: Ni/Au; Cu/Ni; Cu/Al; Cu/Sn; Cu/Au.

7. Component according to any of Claims 1-6,
provided with at least one contrast layer (14) over the metallic cover layer (13), wherein, with a laser inscription, regions (17) of the contrast layer are lifted off while uncovering the cover layer (13).

8. Component according to Claim 7,
embodied as a SAW component with an RF-shielding cover layer (11, 12, 13).

9. Component according to Claim 8,
which is fixed on a panel (2) using flip-chip technology, and wherein the metallic cover layer (13) is applied on the rear side of the component (1) and hermetically seals the latter with respect to the panel (2).

10. Method for producing an inscribable component comprising the steps of:
applying a metallic cover layer on the component,
applying at least one metallic contrast layer on the cover layer directly after applying the cover layer,
wherein the contrast layer is selected or produced under conditions such that it differs from the metallic cover layer with regard to its optical properties.

11. Method according to Claim 10,
wherein the same apparatuses are used for applying the cover layer and the at least one contrast layer.

12. Method according to Claim 10 or 11,
wherein the cover layer and the contrast layer are applied by electroless deposition or electrodeposition.

13. Method according to Claim 10 or 11,
wherein the metallic layers are applied by sputtering.

14. Method according to either of Claims 12 and 13,
wherein the corresponding different optical layer properties of the cover layer and of the contrast layer are set by varying the method parameters or deposition conditions.

15. Method according to either of Claims 12 and 13,
wherein different compositions of the cover layer and of the contrast layer are set by varying the method parameters or deposition conditions.

16. Method according to any of Claims 10-13,
wherein cover layer and contrast layer comprise one of the following layer sequences with different metal colouration, and wherein the layer sequence is applied serially:
e) nickel/gold
f) copper/nickel
g) copper/aluminium
h) copper/tin
i) copper/silver

17. Method according to any of Claims 10-16,
wherein one of the following layer combinations are produced one above another:
a) copper/bright nickel/black nickel
b) bright copper/nickel/black nickel
c) copper/nickel (matt)/nickel (grey)
d) copper/aluminium/aluminium anodized
wherein these layer combinations are applied as contrast layers over the metallic cover layer, or
wherein at least one of the metal layers of said layer sequences are part of the cover layer.

18. Method according to any of Claims 10-17,
wherein layer regions of the at least one contrast layer are subsequently lifted off using a laser,
wherein an inscription or label forming an optical contrast is thereby produced on the component.

## Revendications

1. Composant ayant une couche (11,12,13) métallique de recouvrement, dans lequel sur la couche métallique de recouvrement est disposée au moins une autre couche en métal en tant que couche (14) de contraste, qui forme un contraste visuel avec la couche métallique de recouvrement et qui peut, pour produire une inscription, être enlevée au moyen d'un laser.

2. Composant suivant la revendication 1,
dans lequel on obtient le contraste visuel par le fait que la couche (13) de recouvrement est une couche réfléchissante et la couche (14) de contraste est une couche mate ou l'inverse.

3. Composant suivant l'une des revendications 1 ou 2,
dans lequel on obtient le contraste visuel par le fait que la couche (13) de recouvrement et la couche (14) de contraste sont colorées différemment.

4. Composant suivant l'une des revendications 1 à 3,
dans lequel la couche (14) de contraste est une couche noire et la couche (13) de recouvrement est une couche brillante métalliquement.

5. Composant suivant l'une des revendications 1 à 4,
dans lequel la couche (14) de contraste est une couche de nickel noir.

6. Composant suivant l'une des revendications 1 à 5,
dans lequel la combinaison de la couche (13) de recouvrement et de la couche (14) de contraste englobe l'une des combinaisons de matière suivante : Ni/Au ; Cu/Ni ; Cu/Al ; Cu/Sn ; Cu/Au.

7. Composant suivant l'une des revendications 1 à 6,
pourvu d'au moins une couche (14) de contraste sur la couche (13) métallique de recouvrement dans lequel, par une inscription laser, des parties (17) de la couche de contraste sont enlevées en mettant à nu la couche (13) de recouvrement.

8. Composant suivant la revendication 7,
constitué en composant à montage en surface ayant une couche (11,12,13) de recouvrement protégeant des HF.

9. Composant suivant la revendication 8,
qui est fixé sur un panneau (2) suivant la technique flip chip et dans lequel la couche (13) métallique de recouvrement est déposée sur la face arrière du composant (1) et celui-ci est fermé hermétiquement contre le panneau (2).

10. Procédé de production d'un composant sur lequel on peut écrire comprenant les stades dans lesquels
on dépose une couche métallique de recouvrement sur le composant,
on dépose au moins une couche métallique de contraste sur la couche de recouvrement directement après le dépôt de la couche de recouvrement,
on choisit la couche de contraste ou on la produit dans des conditions telles qu'elle se distingue de la couche métallique de recouvrement par ses propriétés visuelles.

11. Procédé suivant la revendication 10,
dans lequel on utilise pour le dépôt de la couche de recouvrement et de la au moins une couche de contraste les mêmes appareillages.

12. Procédé suivant la revendication 10 ou 11,
dans lequel on effectue le dépôt de la couche de recouvrement et de la couche de contraste par dépôt sans courant ou par dépôt galvanique.

13. Procédé suivant la revendication 10 ou 11,
dans lequel on effectue le dépôt des couches métalliques par pulvérisation cathodique.

14. Procédé suivant l'une des revendications 12 ou 13,
dans lequel on règle les propriétés visuelles différentes adéquates de la couche de recouvrement et de la couche de contraste en faisant varier les paramètres de procédé ou les conditions de dépôt.

15. Procédé suivant l'une des revendications 12 ou 13,
dans lequel on règle des compositions différentes de la couche de recouvrement et de la couche de contraste en faisant varier les paramètres du procédé ou les conditions de dépôt.

16. Procédé suivant l'une des revendications 10 à 13,
dans lequel la couche de recouvrement et la couche de contraste comprennent une des successions de couches suivantes ayant des couleurs de métal différentes et dans lequel on dépose la succession de couches en séquence :
e) nickel/or
f) cuivre/nickel
g) cuivre/aluminium
h) cuivre/étain
i)cuivre/argent

17. Procédé suivant l'une des revendications 10 à 16,
dans lequel on produit de manière superposée l'une des combinaisons de couches suivante :
a) cuivre/nickel brillant/nickel noir
b) cuivre brillant/nickel/nickel noir
c) cuivre/nickel (mat)/nickel (gris)
d) cuivre /aluminium/aluminium anodisé
ces combinaisons de couche étant déposées en tant que couches de contraste sur la couche métallique de recouvrement ou au moins l'une des couches métalliques des successions de couches mentionnées faisant partie de la couche de recouvrement.

18. Procédé suivant l'une des revendications 10 à 17,
dans lequel on enlève ensuite par un laser des parties de la au moins une couche de contraste en produisant ainsi une inscription ou une caractérisation formant un contraste visuel sur le composant.
